# EUROPÄISCHE PATENTSCHRIFT

(11) **EP 3 274 597 B1**
(45) Veröffentlichungstag und Bekanntmachung des Hinweises auf die Patenterteilung: **06.05.2020**
(21) Anmeldenummer: 16712261.3
(22) Anmeldetag: 11.03.2016
(51) Int. Cl.: F16B 33/00, F16B 43/00, H05K 5/00

(54) **ISOLATORELEMENT FÜR EIN GEHÄUSE EINES STEUERGERÄTS**
INSULATING ELEMENT FOR A HOUSING FOR A CONTROL UNIT
ÉLÉMENT ISOLANT POUR UN BOÎTIER D'APPAREIL DE COMMANDE

(30) Priorität: 27.03.2015 DE 102015205629
(43) Veröffentlichungstag der Anmeldung: 31.01.2018
(73) Patentinhaber: Robert Bosch GmbH, 70442 Stuttgart (DE)
(72) Erfinder: SCHNEIDER, David, 8093 Lovasbereny (HU); SZOMBATI, Gergo Roland, 1214 Budapest (HU)
(86) Internationale Anmeldenummer: PCT/EP2016/055238
(87) Internationale Veröffentlichungsnummer: WO 2016/156010

(56) Entgegenhaltungen:
- AT-A4- 509 228
- US-A- 5 020 951
- US-A1- 2012 248 119
- US-B1- 8 544 390

## Beschreibung

### Stand der Technik

Die Erfindung betrifft eine Anordnung mit wenigstens einem Isolatorelement aufweisenden Gehäuse.

Aus dem US 5,020,951 ist ein aus Gummi bestehendes Befestigungselement bekannt, das in eine Durchgangsöffnung einer an einem Motorblock zu befestigenden Einrichtung eingreift. Das aus Gummi bestehende Befestigungselement weist Rasthaken auf, die mit dem zu befestigenden Element eine Rastverbindung ausbilden. Weiterhin weist das Befestigungselement eine Durchgangsöffnung auf, durch die eine Befestigungsschraube montierbar ist, die die Einrichtung an dem Motorblock befestigt.

Auch sind Steuergeräte für Kraftfahrzeuganwendungen in vielfältigsten Ausführungsformen aus dem Stand der Technik bekannt. Derartige Steuergeräte weisen elektrische bzw. elektronische Schaltungen auf, welche üblicherweise nur bis zu einer bestimmten Betriebstemperatur betrieben werden dürfen, um insbesondere eine Beschädigung oder Vorschädigung der in dem Steuergerät vorhandenen elektronischen Bauteile zu verhindern. Darüber hinaus ist es üblich, derartige Steuergeräte über entsprechende Befestigungsmittel beispielsweise unmittelbar im Bereich der Baugruppe anzuordnen, welche von dem betreffenden Steuergeräts angesteuert wird. So ist es insbesondere bereits bekannt, Steuergeräte mit einem Getriebegehäuse zu verbinden, wozu in dem Getriebegehäuse ausgebildete Gewindebohrungen benutzt werden, um das Steuergerät über Befestigungsschrauben an der Oberfläche des Getriebegehäuses zu befestigen. Während des Betriebs des Kraftfahrzeugs bzw. des Getriebes erwärmen sich die innerhalb des Getriebegehäuses angeordneten Bauteile, so dass auch das Getriebegehäuse eine erhöhte Temperatur aufweist. Kritisch sind derartige Anwendungsfälle, bei denen infolge der Ankopplung bzw. Befestigung des Gehäuses des Steuergeräts an dem Getriebegehäuse über das Getriebegehäuse eine derartige Wärme durch eine thermische Kopplung an das Gehäuse des Steuergeräts übertragen wird, dass dadurch in dem Steuergerät die zulässige Betriebstemperatur für die Bauteile des Steuergeräts überschritten wird.

### Offenbarung der Erfindung

Ausgehend von dem dargestellten Stand der Technik liegt der Erfindung die Aufgabe zugrunde, die angesprochene Problematik einer zu großen Wärmeübertragung von einem Trägerelement, an dem das Gehäuse eines Steuergeräts befestigt ist, an das Gehäuse des Steuergeräts zu reduzieren bzw. zu verhindern. Diese Aufgabe wird erfindungsgemäß mit einer Anordnung mit den Merkmalen des Anspruchs 1 gelöst.

Vorteilhafte Weiterbildungen der erfindungsgemäßen Anordnung sind in den Unteransprüchen aufgeführt.

Insbesondere kann es vorgesehen sein, dass das Isolatorelement der Anordnung einen aus einem thermisch schlecht leitenden Material bestehenden Überbrückungsring aufweist, der dazu ausgebildet ist, zwischen dem Gehäuse im Bereich einer Befestigungsöffnung des Gehäuses und einer Befestigungsfläche eines Trägerelements positioniert zu werden, wobei gleichzeitig Rasthaken als Mittel zum Fixieren des Überbrückungsrings im Bereich der Befestigungsöffnung vorgesehen sind. Eine derartige Ausbildung des Isolatorelements bewirkt zum einen eine gewünschte schlechte Wärmeübertragung zwischen einer Befestigungsfläche eines Trägerelements, an der das Steuergerät befestigt ist, und dem Gehäuse des Steuergeräts, und zum anderen eine besonders einfache Montage bzw. Befestigung des Isolatorelements an dem Gehäuse des Steuergeräts. Dadurch, dass das Isolatorelement durch entsprechende Mittel im Bereich der Befestigungsöffnung des Gehäuses des Steuergeräts fixiert sind, wird insbesondere ein Verlierschutz ausgebildet, der die Montage insofern vereinfacht, als dass ein einmal an dem Gehäuse des Steuergeräts befestigtes Isolatorelement auf unbeabsichtigte Art und Weise nicht von dem Gehäuse entfernt werden kann. Insbesondere ist es dadurch möglich, ein derartiges Isolatorelement bereits bei dem Herstellen des Gehäuses vorzusehen, so dass der Anwender bzw. Fahrzeughersteller ohne zusätzlich separate Elemente eine fachgerechte Montage an einem Trägerelement (zum Beispiel dem Getriebegehäuse) lediglich mit Befestigungsmitteln, insbesondere in Form von Befestigungsschrauben, erzielen kann.

Erfindungsgemäß sind Rasthaken als Mittel zum Fixieren des Überbrückungsrings im Bereich der Befestigungsöffnung vorgesehen, wodurch die Mittel eine Rastverbindung mit dem Gehäuse ausbilden. Dadurch wird es ermöglicht, das Isolatorelement nach der eigentlichen Herstellung des insbesondere aus Metall bestehenden Gehäuses mit dem Gehäuse zu verbinden. Insbesondere wird dadurch die Herstellung des Gehäuses im Druckgussverfahren ermöglicht. Bei einer derartigen Herstellung würde ansonsten ein Isolatorelement, das üblicherweise aus einem Kunststoffmaterial besteht, sich nicht in den eigentlichen Fertigungsprozess des Gehäuses integrieren lassen, da es beim Ausbilden des Gehäuses ansonsten zerstört werden würde.

Zur Ausbildung der Rastverbindung wird insbesondere vorgeschlagen, dass wenigstens ein, vorzugsweise mehrere, in gleichmäßigen Winkelabständen zueinander angeordnete Rasthaken am Überbrückungsring vorgesehen sind, die von einer Oberfläche des Überbrückungsrings abragen, und die dazu ausgebildet sind, mit einer Gegenfläche im Bereich der Befestigungsöffnung des Gehäuses zusammenzuwirken. Eine derartige Ausbildung bewirkt insbesondere, dass eine von außen nicht erkennbare und somit auch geschützt angeordnete Rastverbindung zwischen dem Isolatorelement und dem Gehäuse erzielt wird, da der Rasthaken insbesondere in die Befestigungsöffnung des Gehäuses hineinragt.

Ganz besonders bevorzugt ist es darüber hinaus sowohl aus herstellungstechnischen Gründen als auch aus Kostengründen, wenn das Isolatorelement aus Kunststoff besteht und als Spritzgussteil ausgebildet ist. Hierbei kann es insbesondere vorgesehen sein, dass die Mittel zum Fixieren des Überbrückungsrings im Bereich der Befestigungsöffnung einstückig an dem Überbrückungsring angeformt bzw. mit diesem verbunden sind.

Weitere Vorteile, Merkmale und Einzelheiten der Erfindung ergeben sich aus der nachfolgenden Beschreibung bevorzugter Ausführungsbeispiele sowie anhand der Zeichnung.

Diese zeigt in:
- Fig. 1: eine stark vereinfachte Darstellung einer Anordnung eines Gehäuses eines Steuergeräts an einem als Getriebegehäuse ausgebildeten Trägerelement,
- Fig. 2: den Bereich der Unterseite eines Gehäuses des Steuergeräts sowie zweier, in Befestigungsöffnungen des Steuergeräts einsetzbarer Isolatorelemente in perspektivischer Ansicht,
- Fig. 3: ein Isolatorelement in einer perspektivischen Darstellung und
- Fig. 4: den Befestigungsbereich des Gehäuses an dem Getriebegehäuse in einem Längsschnitt.

Gleiche Elemente bzw. Elemente mit gleicher Funktion sind in den Figuren mit den gleichen Bezugsziffern versehen.

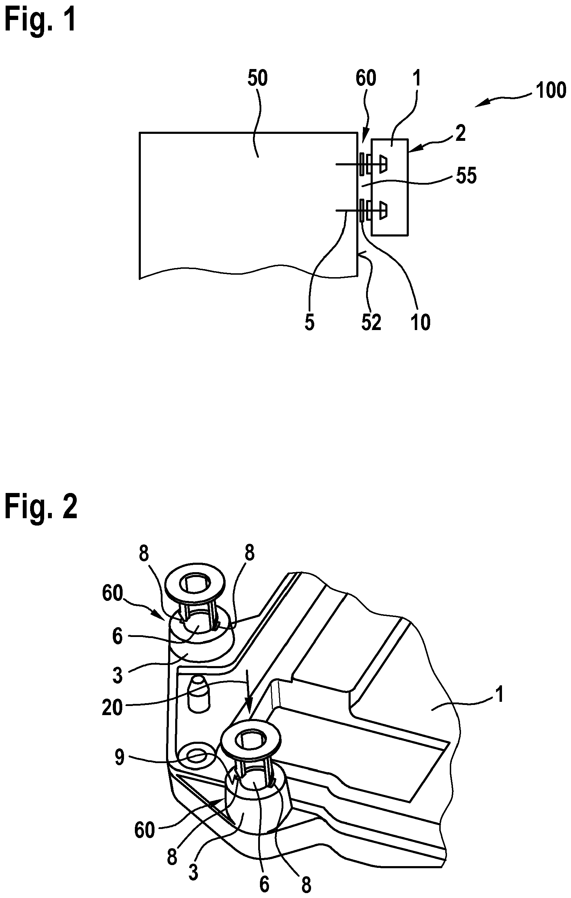

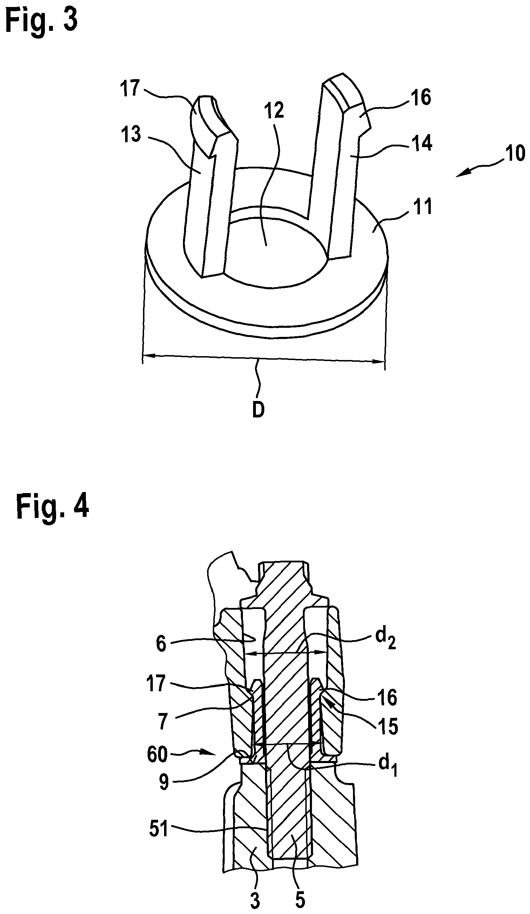

In der Fig. 1 ist stark vereinfacht eine Anordnung 100, bestehend aus einem lediglich bereichsweise dargestellten Trägerelement 50 und dem Gehäuse 1 eines Steuergeräts 2 gezeigt, wobei das Gehäuse 1 beispielhaft über mehrere Befestigungselemente in Form von Befestigungsschrauben 5 mit einer Wand des Trägerelements 50 verbunden ist, wozu das Trägerelement 50 entsprechende Gewindebohrungen 51 (Fig. 4) aufweist.

Bei dem Trägerelement 50 handelt es sich insbesondere, und nicht einschränkend, um ein aus Aluminium bestehendes Getriebegehäuse in einem Kraftfahrzeug, das während des Betriebs eine Temperatur von beispielsweise bis zu 140°C aufweisen kann. Anhand der Fig. 1 ist darüber hinaus erkennbar, dass zwischen dem Gehäuse 1 des Steuergeräts 2 und der Befestigungsfläche 52, an der das Gehäuse 1 befestigt ist, ein Spalt bzw. Abstand 55 ausgebildet ist, der in allen Überdeckungsbereichen des Gehäuses 1 mit der Befestigungsfläche 52 vorhanden ist, mit Ausnahme im Bereich von Befestigungsstellen 60, an denen das Gehäuse 1 über die Befestigungsschrauben 5 mit der Befestigungsfläche 52 verbunden ist.

Entsprechend einer Zusammenschau der Fig. 2 und 4 sind die Befestigungsstellen 60 am Gehäuse 1 des Steuergeräts 2 durch mehrere, domartige Erhöhungen 3 auf der der Befestigungsfläche 52 zugewandten Unterseite des Gehäuses 1 ausgebildet. Das Gehäuse 1 besteht vorzugsweise zumindest im Bereich der Erhöhungen 3 ebenfalls aus Aluminium und ist als Druckgussteil ausgebildet.

Im Bereich der domartigen Erhöhungen 3 weist das Gehäuse 1 darüber hinaus Befestigungsöffnungen für die Befestigungsschrauben 5 in Form von Durchgangsöffnungen 6 auf. Wie anhand der Fig. 4 erkennbar ist, weisen die Durchgangsöffnungen 6 in Längsrichtung betrachtet keinen konstanten Durchmesser auf, sondern einen Durchmesser d₁ im Bereich der der Befestigungsfläche 52 zugewandten Stirnseite der Durchgangsöffnung 6, der sich in etwa in der mittleren Längserstreckung der Durchgangsöffnung 6 zumindest bereichsweise zu einem größeren Durchmesser d₂ erweitert. Im Übergangsbereich zwischen den beiden Durchmessern d₁ und d₂ weist die Durchgangsöffnung 6 eine Übergangsstufe 7 auf. Darüber hinaus ist anhand der Fig. 2 erkennbar, dass die Durchgangsöffnungen 6 beispielhaft an zwei, um 180° zueinander versetzt angeordneten Positionen sich parallel zur Längsachse der Durchgangsöffnung 6 erstreckende Längsnuten 8 aufweisen, die bis in den Bereich der Übergangsstufe 7 reichen.

Um das Gehäuse 1 des Steuergeräts 2 von dem Trägerelement 50 bzw. der Befestigungsfläche 52 thermisch zu entkoppeln, ist es vorgesehen, das Gehäuse 1 im Bereich der Durchgangsöffnungen 6 mit Isolatorelementen 10 auszustatten. Das in der Fig. 3 in Einzeldarstellung gezeigte Isolatorelement 10 besteht aus einem thermisch schlecht leitenden Material, insbesondere aus Kunststoff, und ist für diesen Fall als Spritzgussteil ausgebildet. Das Isolatorelement 10 weist einen Überbrückungsring 11 auf, der eine Öffnung 12 zum Durchführen der Befestigungsschrauben 5 hat. Der Außendurchmesser D des Überbrückungsrings 11 entspricht vorzugsweise dem Außendurchmesser der Erhebungen 3 des Gehäuses 1, wobei die Erhebung 3 eine plane bzw. ebene Stirnfläche 9 aufweist, an der der Überbrückungsring 11 im Einbauzustand flächig anliegt. Weiterhin weist das Isolatorelement 10 zwei, senkrecht von der Oberfläche des Überbrückungsrings 11 abstehende, längliche Rasthakenelemente 13, 14 auf, die einstückig an dem Überbrückungsring 11 angeformt sind und um 180° zueinander versetzt angeordnet sind. Die Rasthakenelemente 13, 14 weisen an ihrem dem Überbrückungsring 11 abgewandten Ende jeweils einen Rasthaken 16, 17 auf, der dazu ausgebildet ist, mit den als Gegenflächen dienenden Übergangsstufen 7 in den Durchgangsöffnungen 6 im Einbauzustand eine Rastverbindung 15 auszubilden. Darüber hinaus ist die Dimensionierung bzw. Anordnung der Rasthakenelemente 13, 14 derart, dass die Isolatorelemente 10 beim Einführen in die Durchgangsöffnungen 6 entsprechend des Pfeils 20 in der Fig. 2 in die Längsnuten 8 eingreifen bzw. darin geführt werden. In der axialen Endposition der Isolatorelemente 10 ist zum einen die Rastverbindung 15 ausgebildet ist, zum anderen liegt der Überbrückungsring 11 an der Stirnseite 9 der Erhebung 3 des Gehäuses 1 an.

In der Fig. 4 ist die Befestigung des Gehäuses 1 an dem Trägerelement 50 im Bereich einer Befestigungsschraube 5 dargestellt. Insbesondere erkennt man, dass die Erhebung 3 und somit das Gehäuse 1 des Steuergeräts 2 nicht unmittelbar an der Befestigungsfläche 52 des Trägerelements 50 anliegt, sondern thermisch entkoppelt durch den Überbrückungsring 11 bzw. das Isolatorelement 10 von dem Trägerelement 50 beabstandet positioniert ist. Dadurch wird beispielsweise gewährleistet, dass das Steuergerät 2 eine zulässige Betriebstemperatur von beispielsweise 120°C nicht überschreitet, obwohl das Trägerelement 50 im Bereich der Befestigungsfläche 52 von 140°C aufweist.

Das soweit beschriebene Isolatorelement 10, das Trägerelement 50 sowie das Gehäuse 1 des Steuergeräts 2 können in vielfältiger Art und Weise abgewandelt bzw. modifiziert werden, ohne vom Erfindungsgedanken abzuweichen.

## Patentansprüche

1. Anordnung (100) mit einem wenigstens ein Isolatorelement (10) aufweisenden Gehäuse (1), wobei das Gehäuse (1) wenigstens eine, vorzugsweise mehrere Befestigungsöffnungen (6) in Form von Durchgangsöffnungen für Befestigungsschrauben (5) aufweist, und wobei im Bereich der wenigstens einen Befestigungsöffnung (6) eine Gegenfläche (7) vorgesehen ist, die dazu ausgebildet ist, mit einem Rasthaken (16, 17) an einem Überbrückungsring (11) des Isolatorelements (10) zusammenzuwirken, und mit einem Trägerelement (50) mit einer Befestigungsfläche (52), wobei das Gehäuse (1) mittels wenigstens einer Befestigungsschraube (5) mit dem Trägerelement (50) verbunden ist, und wobei das Gehäuse (1) zum Trägerelement (50), mit Ausnahme im Bereich des wenigstens einen Überbrückungsrings (11) des Isolatorelements (10), beabstandet angeordnet ist.

2. Anordnung nach Anspruch 1,
**dadurch gekennzeichnet,**
**dass** das Gehäuse (1) zumindest im Bereich der wenigstens einen Befestigungsöffnung (6) aus Metall besteht.

3. Anordnung nach Anspruch 1 oder 2,
**dadurch gekennzeichnet,**
**dass** das Trägerelement (50) während des Betriebs zumindest zeitweise eine höhere Temperatur aufweist als das Gehäuse (1) des Steuergeräts (2).

4. Anordnung nach einem der Ansprüche 1 bis 3,
**dadurch gekennzeichnet,**
**dass** der Überbrückungsring (11) des Isolatorelementes aus thermisch schlecht leitendem Material besteht und dazu ausgebildet ist, zwischen dem Gehäuse (1) im Bereich der Befestigungsöffnung (6) des Gehäuses (1) und einer Befestigungsfläche (52) des Trägerelements (50) positioniert zu werden.

5. Anordnung nach Anspruch 4
**dadurch gekennzeichnet,**
**dass** die Rasthaken als Mittel zum Fixieren des Überbrückungsrings (11) im Bereich der Befestigungsöffnung (6) im Einbauzustand des Isolatorelements (10) dazu ausgebildet sind, eine Rastverbindung (15) mit dem Gehäuse (1) ausbilden.

6. Anordnung nach Anspruch 5,
**dadurch gekennzeichnet,**
**dass** die Mittel zum Fixieren des Überbrückungsrings (11) im Bereich der Befestigungsöffnung (6) wenigstens einen, vorzugsweise mehrere, in gleichmäßigen Winkelabständen zueinander angeordnete Rasthaken (16, 17) umfassen, die von einer Oberfläche des Überbrückungsrings (11) abragen und die dazu ausgebildet sind, mit einer Gegenfläche (7) im Bereich der Befestigungsöffnung (6) zusammenzuwirken.

7. Anordnung nach einem der Ansprüche 1 bis 6,
**dadurch gekennzeichnet,**
**dass** das Isolatorelement (10) aus Kunststoff besteht und als Spritzgußteil ausgebildet ist.

8. Anordnung nach einem der Ansprüche 1 bis 7,
**dadurch gekennzeichnet,**
**dass** die Rasthaken als Mittel zum Fixieren des Überbrückungsrings (11) im Bereich der Befestigungsöffnung (6) einstückig an dem Überbrückungsring (11) angeformt bzw. mit diesem verbunden sind.

## Claims

1. Arrangement (100) comprising a housing (1) having at least one insulator element (10), wherein the housing (1) has at least one fastening opening (6), preferably a plurality of fastening openings (6), in the form of passage openings for fastening screws (5), and wherein a mating surface (7) is provided in the region of the at least one fastening opening (6), which mating surface is designed to interact with a latching hook (16, 17) on a bridging ring (11) of the insulator element (10), and comprising a carrier element (50) with a fastening surface (52), wherein the housing (1) is connected to the carrier element (50) by means of at least one fastening screw (5), and wherein the housing (1) is arranged at a distance from the carrier element (50), apart from in the region of the at least one bridging ring (11) of the insulator element (10).

2. Arrangement according to Claim 1, **characterized in that** the housing (1) consists of metal, at least in the region of the at least one fastening opening (6).

3. Arrangement according to Claim 1 or 2, **characterized in that** the carrier element (50) at least sometimes is at a higher temperature than the housing (1) of the controller (2) during operation.

4. Arrangement according to one of Claims 1 to 3, **characterized in that** the bridging ring (11) of the insulator element consists of a thermally poorly conductive material and is designed to be positioned between the housing (1) in the region of the fastening opening (6) of the housing (1) and a fastening surface (52) of the carrier element (50).

5. Arrangement according to Claim 4, **characterized in that** the latching hooks, as means for fixing the bridging ring (11) in the region of the fastening opening (6) in the installation state of the insulator element (10), are designed to form a latching connection (15) with the housing (1).

6. Arrangement according to Claim 5, **characterized in that** the means for fixing the bridging ring (11) in the region of the fastening opening (6) comprise at least one latching hook (16, 17), preferably a plurality of latching hooks (16, 17) which are arranged at uniform angular distances from one another, which protrudes/protrude from a surface of the bridging ring (11) and which is/are designed to interact with a mating surface (7) in the region of the fastening opening (6).

7. Arrangement according to one of Claims 1 to 6, **characterized in that** the insulator element (10) consists of plastic and is designed as an injection-moulded part.

8. Arrangement according to one of Claims 1 to 7, **characterized in that** the latching hooks, as means for fixing the bridging ring (11) in the region of the fastening opening (6), are integrally formed on the bridging ring (11) or connected to the said bridging ring.

## Revendications

1. Arrangement (100) comprenant un boîtier (1) qui possède au moins un élément isolateur (10), le boîtier (1) possédant au moins une, de préférence plusieurs ouvertures de fixation (6) sous la forme d'ouvertures traversantes pour des vis de fixation (5), et une surface homologue (7) se trouvant dans la zone d'au moins une ouverture de fixation (6), laquelle est configurée pour coopérer avec un crochet d'enclipsage (16, 17) au niveau d'un anneau de pontage (11) de l'élément isolateur (10), et comprenant un élément porteur (50) muni d'une surface de fixation (52), le boîtier (1) étant relié à l'élément porteur (50) au moyen d'au moins une vis de fixation (5) et le boîtier (1) étant disposé espacé de l'élément porteur (50), à l'exception dans la zone de l'au moins un anneau de pontage (11) de l'élément isolateur (10).

2. Arrangement selon la revendication 1, **caractérisé en ce que** le boîtier (1) se compose de métal au moins dans la zone d'au moins une ouverture de fixation (6).

3. Arrangement selon la revendication 1 ou 2, **caractérisé en ce que** pendant le fonctionnement, l'élément porteur (50) présente une température plus élevée que celle du boîtier (1) du contrôleur (2).

4. Arrangement selon l'une des revendications 1 à 3, **caractérisé en ce que** l'anneau de pontage (11) de l'élément isolateur se compose d'un matériau mauvais conducteur thermique et est configuré pour être positionné entre le boîtier (1), dans la zone de l'ouverture de fixation (6) du boîtier (1), et une surface de fixation (52) de l'élément porteur (50).

5. Arrangement selon la revendication 4, **caractérisé en ce que** les crochets d'enclipsage, en tant que moyens servant au calage de l'anneau de pontage (11) dans la zone de l'ouverture de fixation (6) à l'état monté de l'élément isolateur (10), sont configurés pour former un assemblage enclipsé (15) avec le boîtier (1).

6. Arrangement selon la revendication 5, **caractérisé en ce que** les moyens de calage de l'anneau de pontage (11) dans la zone de l'ouverture de fixation (6) comprennent au moins un, de préférence plusieurs crochets d'enclipsage (16, 17) disposés à des écarts angulaires réguliers les uns des autres, lesquels font saillie depuis une surface de l'anneau de pontage (11) et sont configurés pour coopérer avec une surface homologue (7) dans la zone de l'ouverture de fixation (6).

7. Arrangement selon l'une des revendications 1 à 6, **caractérisé en ce que** l'élément isolateur (10) se compose de matière plastique et est réalisé sous la forme d'une pièce moulée par injection.

8. Arrangement selon l'une des revendications 1 à 7, **caractérisé en ce que** les crochets d'enclipsage, en tant que moyens servant au calage de l'anneau de pontage (11) dans la zone de l'ouverture de fixation (6), sont façonnés d'un seul tenant sur l'anneau de pontage (11) ou reliés d'un seul tenant à celui-ci.
